# EUROPEAN PATENT APPLICATION

(11) **EP 4 265 333 A1**
(43) Date of publication of application: **25.10.2023**
(21) Application number: 22169561.2
(22) Date of filing: 22.04.2022
(51) Int. Cl.: B01L 7/00, H01L 27/16, H01L 35/18, H01L 35/32

(54) **A SEMICONDUCTOR STRUCTURE AND A MICROFLUIDIC SYSTEM THEREOF**

(71) Applicant: Epinovatech AB, 223 63 Lund (SE)
(72) Inventor: OLSSON, Martin Andreas, 223 63 Lund (SE)
(74) Representative: AWA Sweden AB

(57) **Abstract**

A semiconductor structure (200) and a microfluidic system (300) comprising the semiconductor structure (200) are disclosed. The semiconductor structure (200) comprises a thermoelement layer (120). The thermoelement layer (120) comprises p- (120p) and n-type (120n) thermoelements. These thermoelements (120p, 120n) form regions (R1, R2, R3) wherein respective region is associated with a specific temperature range, where achieving the specific temperature range is based on an electron or hole current flowing through the thermoelements (120, 120p, 120n). The semiconductor structure (200) forms part of the microfluidic system (300) comprising a microfluidic channel (320) having a meander extension across regions (R1, R2, R3) having different temperature ranges. This allows a fluid flowing in the microfluidic channel (320) being exposable to cyclic temperature variations.

## Description

### TECHNICAL FIELD

The present disclosure belongs to semiconductor structures and microfluidic systems thereof.

### BACKGROUND

Rapid test devices for testing infectious disease have recently become a necessity as of the global pandemic caused by the covid-19 due to the severe health restrictions required to go to work, move around in society, etc. Such test devices are typically of antigen type, which recently have become relatively cheap. However, accuracy may be questioned in the event of, e.g. possible mutations of a specific virus type. To increase accuracy reference is often made to a test of so-called polymerase chain reaction, PCR, type. PCR is a common molecular biology technique enabling multiple copies of a DNA sequence, capable of efficiently amplifying DNA or RNA sequences from various sources. This is conventionally achieved by employing a DNA polymerase. DNA polymerase is a holoenzyme that comprises 10 subunits, a beta subunit clamp, a core polymerase that consists of an alpha, theta and epsilon subunits and a gamma complex. The polymerase may be Taq polymerase, i.e., DNA polymerase I from Thermus aquaticus which is representative for thermostable DNA polymerases. The PCR method further employs the following three-step procedure:(i) DNA is denatured by heating to 90-95°C, which separates double-stranded DNA to single-stranded DNA. The DNA strand is a double helix that consists of two single DNA strands. Each of the DNA strands consists of monomeric units called nucleotides forming a sugar backbone. The forward direction of the DNA strands is in the 5'-to-3' direction. During denaturation close to the boiling point of water, the hydrogen bonds between the nucleobases becomes weaker and hence the two strands separates into two. When cooling down the denaturated DNA, primer DNA becomes assembled. (ii) In this subsequent annealing step, the sample is cooled to 40-60°C, allowing primers to attach to the target DNA. Each primer DNA consists of a chain of a DNA strand in the beginning of the sequence for replication. (iii) Finally, the sample is heated to 70-75°C such that DNA polymerase extends the DNA from the primers creating a new double-stranded DNA with the old strand and a new strand. DNA is always synthesized in the 5'-to-3' direction. Upon heating, elongation of the DNA double strand occurs with nucleotides that are added to the 3' end, i.e., the 5' phosphate group of the new nucleotide binds to the 3' hydroxyl group of the last nucleotide. By cyclic repetition of the above steps (i)-(iii), the number of DNA copies doubles for each cycle such that the number of DNA copies approximately increases by three orders of magnitudes per ten cycles.

While DNA for a PCR test can be provided in a home environment through saliva or blood samples, the actual PCR test normally takes place on a hospital or a health center. This since conventional PCR apparatuses are sophisticated thermocycler machines being programmed to alter the temperature of the reaction every few minutes to allow DNA denaturing and synthesis. Further, these apparatuses are relatively expensive. Needless to say, this may cause inconvenience for infected persons, persons living in sparsely populated areas, etc.

Hence, there is a need for a more flexible and mobile approach for carrying out an accurate test for infectious disease.

### SUMMARY

The main object of the invention is to provide a more flexible and mobile approach for carry out an accurate test for infectious disease.

Another object is to provide a small and portable approach for exerting a liquid to rapid temperature variations.

According to a first aspect, a semiconductor structure is provided. The semiconductor structure comprises: a substrate having a top surface; and a thermoelement layer. The thermoelement layer comprises different portions and sublayers. The thermoelement layer comprises: a plurality of vertical p-type semiconductor pillars arranged perpendicularly to the top surface of the substrate, each vertical p-type semiconductor pillar having a bottom end facing the top surface of the substrate, and a top end facing away from the top surface of the substrate, the plurality of vertical p-type semiconductor pillars being clustered into one or more sets of p-type semiconductor pillars, wherein each of the one or more sets of p-type semiconductor pillars constitutes a p-type thermoelement; and a plurality of vertical n-type semiconductor pillars arranged perpendicularly to the top surface of the substrate, each vertical n-type semiconductor pillar having a bottom end facing the top surface of the substrate, and a top end facing away from the top surface of the substrate, the plurality of vertical n-type semiconductor pillars being clustered into one or more sets of n-type semiconductor pillars, wherein each of the one or more sets of n-type semiconductor pillars constitutes a n-type thermoelement. The n-type and p-type thermoelements are located at distance from each other such that a space is formed between the n-type and p-type thermoelements. The thermoelement layer further comprises a bottom contact layer defining a plurality of discrete bottom contact portions, wherein each bottom contact portion connecting the bottom ends of the vertical p-type semiconductor pillars of a specific p-type thermoelement forming a bottom contact of the specific p-type thermoelement or connecting the bottom ends of the vertical n-type semiconductor pillars of a specific n-type thermoelement forming a bottom contact of the specific n-type thermoelement. The thermoelement layer further comprises a top contact layer defining a plurality of discrete top contact portions, wherein each top contact portion connecting the top ends of the vertical p-type semiconductor pillars of a specific p-type thermoelement forming a top contact of the specific p-type thermoelement or connecting the top ends of the vertical n-type semiconductor pillars of a specific n-type thermoelement forming a top contact of the specific n-type thermoelement.

A *semiconductor pillar* as discussed herein may be a semiconductor nanopillar, a semiconductor micropillar, or any suitable pillar of semiconductor type. Preferably, the semiconductor pillar may be viewed as a semiconductor nanopillar.

The *semiconductor structure* may be viewed as a *semiconductor layer structure* and occasionally denoted so.

Elemental materials are referred to herein by their element symbol or abbreviation. For example, gallium nitride may typically be referred to as GaN and aluminum gallium nitride may be referred to as AIGaN. In general, layers or structures said to comprise a specific material or element, may be understood as at least partially comprising or substantially consisting of the specific material or element. The layers of the semiconductor structure may be understood as ordered in a "bottom up" order. In this context the term "on" refers to arranging layers or structures above or onto other layers or structures. The term "vertical" refers to the direction in which layers are arranged on each other. The vertical direction is considered perpendicular or normal to the top surface of the substrate, wherein the top surface may be considered to be substantially planar. The term "laterally" refers to any direction being perpendicular to the vertical direction.

The semiconductor structure is configured for generation of the Peltier effect. That is, cooling of one junction and heating of another junction may be achieved while an electrical current is maintained in a circuit of material comprising two different conductor types. The use of semiconductors representing the different junctions, e.g. p- and n-type semiconductors, possibly based on the same base material, may further pronounce the Peltier effect. Hence, this structure may facilitate provision of a thermoelement capable of generating temperature differences over relatively small distances. Further, this may facilitate manufacturing of a relatively small and cheap structure.

The p-type semiconductor pillars may be clustered into a plurality of sets of p-type semiconductor pillars, and the n-type semiconductor pillars may be clustered into a plurality of sets of n-type semiconductor pillars, and the bottom contact portions of the bottom contact layer may be arranged to connect bottom contacts of the n-type thermoelements and bottom contacts of the p-type thermoelements and top contact portions of the top contact layer may be arranged to connect top contacts of the n-type thermoelements and the top contacts of the p-type thermoelements such that the n-type and p-type thermoelements are connected in series.

Hence, the p- and n-type semiconductor pillars may form a grid consisting of a relatively large number of semiconductor pillars, where each semiconductor pillar form a small cell of the grid. The heating or cooling capacity scales linearly with the number of cells of the grid. Hence, a grid consisting of a relatively large number of relatively small cells may facilitate generation of significant temperature gradients over short distances. For practical (manufacturing technical) reasons the grid may be regular.

The space between the n-type and p-type thermoelements may comprise a passivating material. The passivating material may be a thermally and electrically insulating material. This may facilitate an improved control of heat transfer between the thermoelements. Further, this may facilitate reducing leakage of heat and electrical current.

The p-type semiconductor pillars may comprise InₓGa₁₋ₓN, wherein 0.2<x<0.35, and wherein the n-type semiconductor pillars comprises In_{y}Ga_{1-y}N, wherein 0.2<y<0.35. Preferably, x and y may be such that the charge carrier concentration is approximately in the range of 10¹⁶-10¹⁸ cm⁻³ for the p- and n-type semiconductor pillars respectively, where it is appreciated that the charge carriers for the p-type (n-type) semiconductor pillars are holes (electrons). Such a relatively large difference in charge carrier concentration may facilitate provision of abrupt temperature differences over small distances.

The bottom contact layer may comprise doped GaN. The doped GaN may be relatively highly doped GaN. The highly doped GaN may comprise at least a carrier concentration of silicon or magnesium atoms of 10¹⁶ cm⁻³.

The top contact layer may be metallic. A metallic top contact layer may facilitate a fast heat transfer and a high electrical conductivity.

The p-type semiconductor pillars may comprise a superlattice of InₓGa₁₋ₓN and GaN, wherein 0.2<x<0.35, and InN, and wherein the n-type semiconductor pillars comprises a superlattice of In_{y}Ga_{1-y}N, wherein 0.2<y<0.35, and InN. The superlattice may have a periodicity between 2-20 nm between InₓGa₁₋ₓN segments along the axial direction of the pillars. Nitride-based InN/InGaN superlattices may facilitate improved thermoelectric properties compared to, e.g. conventional bulk-like ternary nitride alloy alternatives.

The substrate may comprise Si. A silicon base layer allows a thicker GaN to be deposited/grown thereon to improve crystal quality without manufacturing complications involved by formation of the crystalline GaN/AIGaN layer structure. Other materials may be possible such as silicon carbide, SiC. However, pure silicon is preferable as of its relatively low cost.

The semiconductor structure may further comprise a supporting layer arranged in between the Si-substrate and the thermoelement layer, wherein the supporting layer comprises: a first semiconductor layer arranged on the Si-substrate, the first semiconductor layer comprising a plurality of vertical nanowire structures arranged perpendicularly to the top surface of the Si-substrate, the first semiconductor layer comprising AIN; and a second semiconductor layer arranged on the first semiconductor layer laterally and vertically enclosing the nanowire structures, the second semiconductor layer comprising Al_{z}Ga_{1-z}N, wherein 0≤z≤0.95. Such an AIN layer may be arranged above a silicon base layer and below any GaN and/or AI(1-x)Ga(x)N layers. Due to factors such as crystal lattice constants and thermal expansion coefficients being different for silicon and nitride materials, just forming a nitride layer onto a silicon layer will most often result in cracks, defects and overall poor crystal quality of the formed nitride layers due to, e.g., mismatching material properties. Hence, an AIN layer facilitate a smoother material transition between a silicon base layer and any GaN and AI(1-x)Ga(x)N layers, thereby providing an adequate electron or hole mobility through the support structure.

According to a second aspect, a microfluidic system is provided. The microfluidic system comprises a semiconductor structure according to the first aspect, wherein the thermoelement layer is vertically divided in two or more regions wherein each region comprises at least one n-type thermoelement and at least one p-type thermoelement constituting a thermoelectric unit, wherein each thermoelectric unit is configured to supply a specific temperature upon a fixed current is running therethrough. The microfluidic system further comprises a microfluidic channel layer arranged above the thermoelement layer, the microfluidic channel layer comprising a microfluidic channel having a meander extension across the two or more regions of the thermoelement layer such that a fluid, while being transported in the channel, is exposable to a cyclic temperature variation.

Hence, a fluid comprising DNA may be exposed for cyclic temperature variations while being transported in the microfluidic channel. Preferably, the meander extension of the microfluidic channel may be configured to provide 10-50 temperature cycles during transport in the microfluidic channel. The microfluidic system may facilitate a relatively small and portable system for performing a polymerase chain reaction, PCR. Further, a faster PCR for analysis may be provided.

The microfluidic channel layer may be made from a plastic material. This may facilitate a low-friction transport of fluid. Further, cleaning and flushing may be facilitated.

The microfluidic channel may comprise an inlet and an outlet.

The microfluidic system may further comprise a detector for detecting a biomarker. The detector may comprise an InGaN laser, a microring resonator, and a transducer. The detector may detect deviations for analyzed DNA. The microring resonator may provide high detection accuracy in that small deviations for analyzed DNA may be possible. The InGaN laser, the microring and the transducer may be arranged above the semiconductor layer structure in the same plane as the microfluidic channel monolithically. In particular, the InGaN laser may be formed in a quantum well heterostructure. Such a quantum well heterostructure may comprise GaN / InGaN / GaN disposed on top of said semiconductor layer structure. Al GaN / AI(1-x)Ga(x)N heterostructure with the composition 0.2 < x < 0.35 formed above the quantum well heterostructure. The microring may be plasma etched or wet etched from a GaN layer. Alternatively, an InGaN laser, a microring, and a transducer may be packaged from a separate chip die together with the semiconductor layer structure herein.

The microring may comprise a gold layer arranged on a top side or on a bottom side of the microring.

The microfluidic system may be configured for polymerase chain reaction, wherein the thermoelement layer is vertically divided in at least three regions. A first region may comprise at least one n-type thermoelement and at least one p-type thermoelement constituting a first thermoelectric unit configured to supply a temperature of 95°C ±5%, for denaturation. A second region may comprise at least one n-type thermoelement and at least one p-type thermoelement constituting a second thermoelectric unit configured to supply a temperature of 56°C ±5% for annealing of primers.

A third region may comprise at least one n-type thermoelement and at least one p-type thermoelement constituting a third thermoelectric unit configured to supply a temperature of 72°C ±5%, for extension by polymerase.

The first and third regions may abut the second region forming a temperature gradient therebetween.

The microfluidic channel may have a meander extension across the at least three regions of the thermoelement layer such that a fluid, while being transported in the channel, is exposable to a cyclic temperature variation.

The microfluidic system may be integrated in an electronic device. The electronic device may be a computer, a computer tablet, a smart phone, a smart watch, or the like. This may further facilitate portability of the microfluidic system such that analysis of a PCR test may be performed at home, or at any other suitable location.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### BRIEF DESCRIPTION OF THE DRAWINGS

The above, as well as additional objects, features, and advantages of the present invention, will be better understood through the following illustrative and non-limiting detailed description of preferred embodiments, with reference to the appended drawings, where the same reference numerals will be used for similar elements, wherein:
Fig. 1 shows, highly schematically, a side view of a semiconductor layer structure.
Fig. 2 shows, highly schematically, a microfluidic system.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

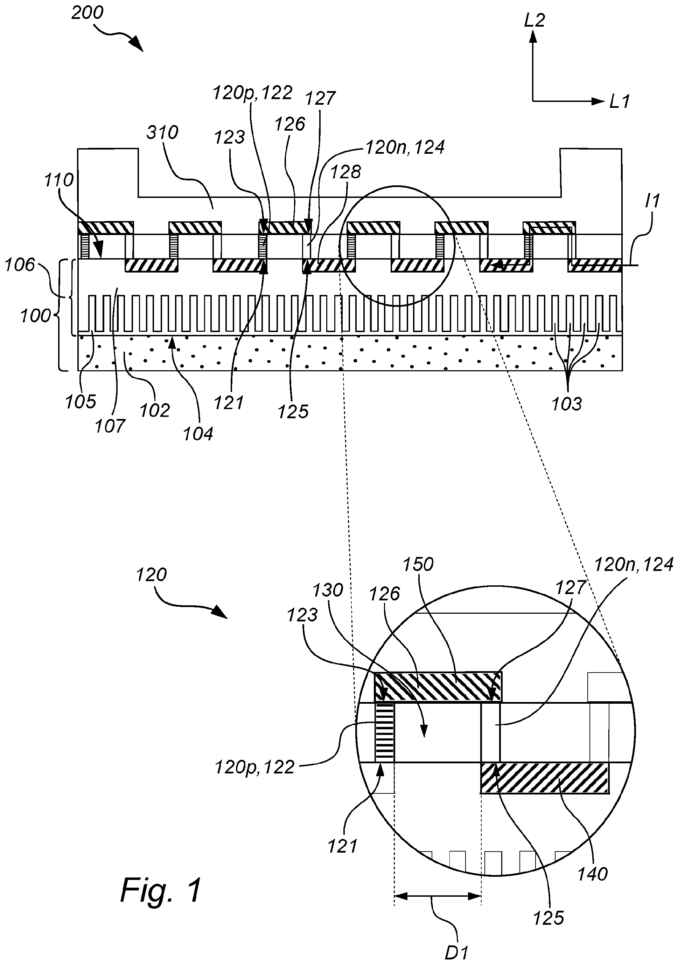

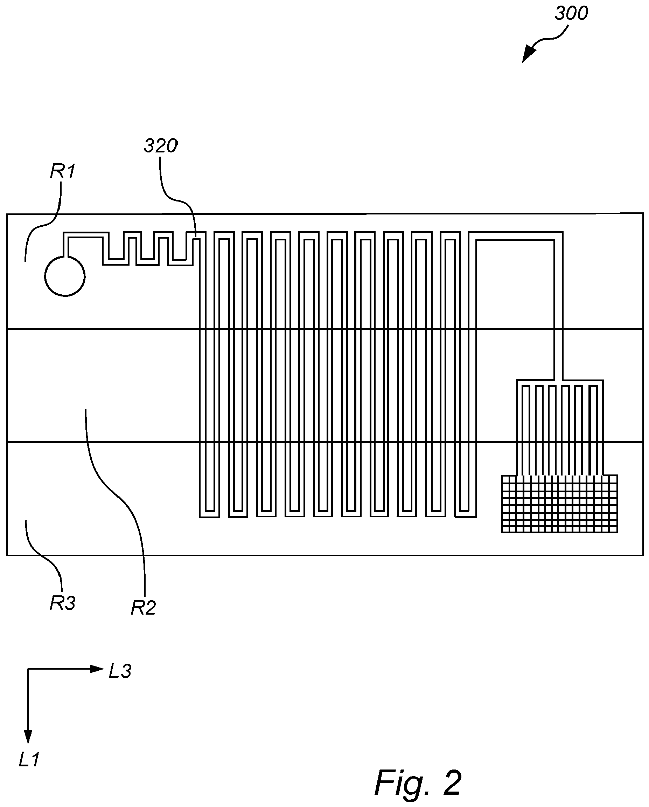

In connection with Fig. 1, there is shown a general structure of a semiconductor structure 200 seen from a side view. This side view is here represented by an orthogonal coordinate system having a first extension L1 and a second extension L2, such that the side view is represented in the L1-L2 plane. A third extension L3 (see Fig. 2) extends perpendicularly to the L1-L2 plane. Throughout, the second extension L2 refers to the "vertical" extension/direction, although the semiconductor may have any spatial orientation during manufacturing or in use, etc. Other terms, such as "bottom" or "top" thereby refer to differently elevated locations along the second extension L2.

The semiconductor layer structure comprises a substrate 100 having a top surface 110. The semiconductor layer structure comprises a thermoelement layer 120. The thermoelement layer 120 comprises different portions and sublayers.

The thermoelement 120 layer comprises a plurality of vertical p-type semiconductor pillars 122 arranged perpendicularly to the top surface 110 of the substrate 100. Each vertical p-type semiconductor pillar 122 has a bottom end 121 facing the top surface 110 of the substrate 100, and a top end 123 facing away from the top surface 110 of the substrate 100. The plurality of vertical p-type semiconductor pillars 122 are clustered into one or more sets of p-type semiconductor pillars. Each of the one or more sets of p-type semiconductor pillars 122 constitutes a p-type thermoelement 120p. Hence, in Fig. 1, there is, in a non-limiting fashion, shown six such p-type thermoelements 120p. Each p-type thermoelement 120p may be configured to maintain a specific temperature upon being traversed with an electrical current. The specific temperature may be tuned by the physical dimension of individual parts of the p-type thermoelement 120p, a specific dopant level of individual parts of the p-type thermoelement 120p, an individually set current flowing through the p-type thermoelement 120p, or the like. The plurality of vertical p-type semiconductor pillars 122 may be arranged along the third extension L3, i.e., into or outwards from the paper/screen of Fig. 1. Hence, the plurality of vertical p-type semiconductor pillars 122 of the one or more sets of p-type semiconductor pillars 122 may form a two-dimensional grid (in the L2-L3 plane) when seen from above, i.e., along the second extension L2.

The thermoelement 120 layer further comprises a plurality of vertical n-type semiconductor pillars 124 arranged perpendicularly to the top surface 110 of the substrate 100. Each vertical n-type semiconductor pillar 124 has a bottom end 125 facing the top surface 110 of the substrate 100, and a top end 127 facing away from the top surface 110 of the substrate 100. The plurality of vertical n-type semiconductor pillars 124 are clustered into one or more sets of n-type semiconductor pillars 124. Each of the one or more sets of n-type semiconductor pillars constitutes an n-type thermoelement 120n. Hence, in Fig. 1, there is, in a non-limiting fashion, shown six such n-type thermoelements 120n. Each n-type thermoelement 120n may be configured to generate and/or maintain a specific temperature upon being traversed with an electrical current. The specific temperature may be tuned by the physical dimension of individual parts of the n-type thermoelement 120n, a specific dopant level of individual parts of the n-type thermoelement 120n, an individually set current flowing through the n-type thermoelement 120n, or the like. The plurality of vertical n-type semiconductor pillars 124 may be arranged along the third extension L3, i.e., into or outwards from the paper/screen of Fig. 1. Hence, the plurality of vertical n-type semiconductor pillars 124 of the one or more sets of n-type semiconductor pillars 124 may form a two-dimensional grid (in the L1-L3 plane) when seen from above, i.e., along the second extension L2.

The n-type and p-type thermoelements 120p, 120n may be located at distance a D1 from each other such that a space 130 is formed between the n-type and p-type thermoelements. Preferably, the distance D1 may be substantially constant at different locations along the third extension L3. Alternatively, the distance D1 may vary between different locations along the third extension L3.

The thermoelement layer 120 further comprises a bottom contact layer 140 defining a plurality of discrete bottom contact portions 140. Each bottom contact portion 140 connects the bottom ends 121 of the vertical p-type semiconductor pillars 122 of a specific p-type thermoelement 120p forming a bottom contact of the specific p-type thermoelement 120p. Alternatively, or in combination, each bottom contact portion 140 connects the bottom ends 125 of the vertical n-type semiconductor pillars 124 of a specific n-type thermoelement 120n forming a bottom contact of the specific n-type thermoelement 120n.

The thermoelement 120 further comprises a top contact layer 150 defining a plurality of discrete top contact portions. Each top contact portion 150 connects the top ends 123 of the vertical p-type semiconductor pillars 122 of a specific p-type thermoelement 120p forming a top contact of the specific p-type thermoelement 120p. Alternatively, or in combination, each top contact portion 150 connects the top ends 127 of the vertical n-type semiconductor pillars of a specific n-type thermoelement forming a top contact of the specific n-type thermoelement 120n.

Bottom contact portions 140 of the bottom contact layer are arranged to connect bottom contacts 125 of n-type thermoelements 120n and bottom contacts 121 of p-type thermoelements 120p and top contact portions 150 of the top contact layer are arranged to connect top contacts 127 of n-type thermoelements 120n and top contacts 123 of the p-type thermoelements 120p such that the n-type 120n and p-type 120p thermoelements are connected in series.

The top contact portions 150 receives conduction-band electrons from the n-type thermoelements 120n. A substantially equal number of electrons thereby has to enter into valence-band holes originating from the p-type thermoelements 120p to thereby eliminate the holes. This lowers the energy of the electrons, thereby increasing the temperature of the top contact portions 150. In parallel, the bottom contact portions 140 withdraws holes from the valence band of a p-type thermoelement 120p, resulting in outgoing holes therefrom. Electrons are thereby injected into the conduction band of an adjacent n-type thermoelement 120n, i.e., requiring energy in that the temperature decreases for the bottom contact portion 140. The n-type 120n and p-type 120p thermoelements thereby provide the energy level of the valance band of the n-type thermoelement 120n and the conduction band of the p-type semiconductor 120p to be substantially smaller than the bandgap of either of the semiconductors. Hence, a current of electrons or holes may flow through a plurality of interconnected thermoelements between ends along the first extension L1. A portion I1 of the path of the electrical (or hole) current can be seen in Fig. 1.

The space 130 between the n-type 120n and p-type 120p thermoelements may comprise a passivating material. The passivating material may be electrically and thermally insulating. By way of example, the passivating material may comprise in-situ MOCVD grown silicon nitride.

The p-type semiconductor pillars 122 may comprise InₓGa₁₋ₓN, wherein 0.2<x<0.35. The n-type semiconductor pillars 124 may comprise In_{y}Ga_{1-y}N, wherein 0.2<y<0.35. Preferably, x and y may be such that the charge carrier concentration is approximately 10¹⁵ cm⁻³ for the p- and n-type semiconductor pillars, respectively, where it is appreciated that the charge carriers for the p-type (n-type) semiconductor pillars are holes (electrons).

The bottom contact layer 140 may comprise doped GaN. Any suitable dopant may be possible for provision of a bandgap allowing a sufficient electron or hole transport through the thermoelements 120.

The top contact layer 150 may be metallic. Non-limiting examples are tungsten, gold, copper, or silver.

The p-type semiconductor pillars 122 may comprise a superlattice of InₓGa₁₋ₓN, wherein 0.2<x<0.35, and InN. The superlattice may thereby comprise a plurality of layers stacked along the second extension L2, where every other layer (0, 2, 4, ..., 2N) comprises InₓGa₁₋ₓN, and every other layer (1, 3, 5, ..., 2N+1) comprises InN.

The substrate 102 may comprise silicon, Si. The silicon may be formed as a silicon base layer for the semiconductor structure 200. The silicon base layer 102 may form part of the substrate 100 in that the silicon base layer 102 is a relatively large silicon wafer on which AIN may be grown (further discussed below). The substrate 100 may thereby comprise a silicon bulk material 102. A top surface 104 of the silicon base layer 102 may be substantially planar. The vertical thickness of the silicon base layer may be in the range 100-1000 µm, and more preferably in the range 275-525 µm. If not explicitly stated otherwise, thickness will henceforth refer to vertical thickness. The top surface 104 of the silicon base layer 102 may have Miller indices (111). The silicon base layer 102 may have a diamond-cubic crystal structure.

The semiconductor structure 200 may further comprise a supporting layer 106 arranged in between the Si substrate 102 and the thermoelement layer 120. The supporting layer 106 may comprise a first semiconductor layer 105 arranged on the Si-substrate 102. The first semiconductor layer 105 may comprise a plurality of vertical nanowire structures 103 arranged perpendicularly to the top surface 104 of the Si substrate 102. The first semiconductor layer 105 may comprise an aluminum nitride, AIN, layer 105. The AIN layer 105 may preferably have a thickness in the range 100-500 nm and more preferably a thickness in the range 200-300 nm. The AIN layer may comprise vertical nanowire structures 103. These nanowires 103 may preferably have a vertical length in the range 50-500 nm and more preferably a vertical length in the range 150-250 nm. The vertical nanowire structures 103 may preferably have a substantially circular or hexagonal lateral cross section profile. A diameter of such a nanowire may be in the range 5-50 nm and more preferably 10-30 nm. The nanowires 103 may be arranged in a repeating array pattern seen in the vertical direction where each nanowire 103 has four equidistant closest other nanowires. Alternatively, the repeating array pattern may have a square pattern. A distance between adjacent nanowires 103 may preferably be in the range 10-500 nm, and more preferably in the range 50-200 nm.

The supporting layer 106 may further comprise a second semiconductor layer 107. The second semiconductor layer 107 may be arranged on the first semiconductor layer 105 laterally and vertically enclosing the nanowire structures 103. The second semiconductor layer 107 may comprise Al_{z}Ga_{1-z}N, wherein 0≤z≤0.95. Alternatively, the second semiconductor layer 107 may comprise GaN. The second semiconductor layer 107 may preferably have a thickness in the range 100-500 nm and more preferably a thickness in the range 200-300 nm. The second semiconductor layer 107 may be considered to laterally enclose, encapsulate, or encompass the vertical nanowire structures 103, i.e., filling in the space between the vertical nanowire structures 103. The second semiconductor layer 107 may further be considered to vertically enclose or encapsulate the vertical nanowire structures 103, i.e. extending vertically above and covering top portions of the vertical nanowire structures 103.

The second semiconductor layer 107 may attach directly to the thermoelement layer 120.

Each bottom contact portion 140 may be etched into the second semiconductor layer 107. Regions between adjacent bottom contact portions 140 may comprise n-doped GaN. These n-type GaN layers may be lithographically patterned, and plasma etched. The lithographical patterning may be utilized by nanoimprint lithography.

In connection with Fig. 2, there is shown a highly schematic microfluidic system 300. The microfluidic system 300 comprises a semiconductor structure 200. Further details of the semiconductor layer structure may be as set out above. The thermoelement layer 120 is vertically divided in two or more regions R1, R2, R3. The term *vertically divided* herein refers to a spatial separation along the first extension L1. Each region comprises at least one n-type thermoelement 120n and at least one p-type thermoelement 120p constituting a thermoelectric unit. Each thermoelectric unit is configured to supply a specific temperature upon a fixed current is running therethrough. Hence, the fixed current may be a direct current, DC. As set out above, the fixed current of a specific thermoelectric unit may provide a specific temperature depending on, e.g., physical dimensions of the thermoelectric unit, electrical properties of the thermoelectric unit originating from involved metal types or metal compounds in the unit, a combination of the physical dimensions and the electrical properties, etc.

The microfluidic system 300 further comprises a microfluidic channel layer 310; see Fig. 1. The microfluidic channel layer 310 may be made of a polymer or any other material having similar properties as polymer. The microfluidic channel layer 310 may be located vertically directly above the thermoelement layer 120, the microfluidic channel layer 310 being printed or casted thereto.

The microfluidic channel layer 310 comprises a microfluidic channel 320 having a meander extension across the two or more regions R1, R2, R3 of the thermoelement 120 layer such that a fluid, while being transported in the channel 320, is exposable to a cyclic temperature variation.

In Fig. 2 the microfluidic system is seen along the second extension L2, i.e., in the L1-L3 plane. Further, three regions, i.e., a first region R1, a second region R2, and a third region R3 are exemplified herein. Preferably, adjacent regions may be mutually spatially separated by a substantially straight line. Alternatively, adjacent regions may be mutually spatially separated by a curved line. The regions R1, R2, R3 are further described below.

The microfluidic channel layer 320 may be made from a plastic material. Preferably, an interior surface of the microfluidic channel in which the fluid can flow, may be passivated using epoxy polydimethylacrylamide, epoxy polydimethylsiloxane, or the like. This may reduce the potentially inhibitory effects of certain materials in enzymatic reactions possibly occurring in the microfluidic channel 320.

The microfluidic system 300 may comprise a mechanical micropump. The micropump may be a diaphragm.

The microfluidic channel 320 may comprise an inlet and an outlet (not shown).

The microfluidic system 300 may further comprise a detector for detecting a biomarker. The detector may comprise an InGaN laser. The laser comprises a laser source. The laser source may comprise a plurality of InGaN quantum wells. The detector may further comprise a microring resonator. The detector may further comprise a transducer.

The microring may comprise a gold layer arranged on a top side or a bottom side of the microring.

The microfluidic system 300 may be configured for polymerase chain reaction, PCR. Hence, it is preferable that the thermoelement layer is vertically divided in at least three regions, as mentioned previously.

A first region R1 may comprise at least one n-type thermoelement 120n and at least one p-type thermoelement 120p. These constitute a first thermoelectric unit configured to supply a temperature of 95°C ±5% for denaturation. The denaturation step typically includes double stranded DNA to denaturate into two single strands.

A second region R2 may comprise at least one n-type thermoelement 120n and at least one p-type thermoelement 120p. These constitute a second thermoelectric unit configured to supply a temperature of 56°C ±5% for annealing of primers. Primers, i.e., relatively short complementary sequences of DNA, can anneal to the single stranded target DNA. An exponential increase of double stranded DNA concentration may be obtained by cyclic repetition of the fluid, e.g. blood, being exposed to the above regions R1, R2, R3, each region supplying a specific temperature. This since the number of double stranded DNA doubles for each cycle. To this end, the second region R2 may abut the first R1 and the third R3 region such that the second region R2 is located between the first R1 and the third R3 region. Further, the microfluidic channel 320 may have a meander extension across the at least three regions of the thermoelement layer such that a fluid, while being transported in the microfluidic channel, is exposable to a cyclic temperature variation.

A third region R3 may comprise at least one n-type thermoelement 120n and at least one p-type thermoelement 120p. These constitute a third thermoelectric unit configured to supply a temperature of 72°C ±5% for extension by polymerase. Here the polymerase may gain activity in that synthesis of a second complementary strand of DNA can be done from free nucleotides in the fluid. The microfluidic system 300 may be integrated in an electronic device. The electronic device may be a smartphone, a computer tablet, a smart watch, or the like. In one embodiment of the invention the microfluidic pump may be a capillary pump arranged in the microfluidic channel above the semiconductor layer structure. The microfluidic pump may comprise micropillars or pillars in a hexagonal or cubic pattern. The distance or pitch of the micropillars or pillars may be configured in order to provide the capillary pumping action. In other embodiments, the microfluidic pump may be based on any of the following types: mechanical, geometric, hydrophobic, pneumatic, thermopneumatic, phase-change, electrostatic, piezoelectric, or based on thermal expansion. The person skilled in the art realizes that the present invention by no means is limited to the examples described above. On the contrary, many modifications and variations are possible within the scope of the appended claims.

## Claims

1. A semiconductor structure (200) comprising:
a substrate (100) having a top surface (110);
a thermoelement layer (120) comprising:
a plurality of vertical p-type semiconductor pillars (122) arranged perpendicularly to the top surface (110) of the substrate (100), each vertical p-type semiconductor pillar (122) having a bottom end (121) facing the top surface (110) of the substrate (100), and a top end (123) facing away from the top surface (110) of the substrate (100), the plurality of vertical p-type semiconductor pillars (122) being clustered into one or more sets of p-type semiconductor pillars (122), wherein each of the one or more sets of p-type semiconductor pillars (122) constitutes a p-type thermoelement (120p), and
a plurality of vertical n-type semiconductor pillars (124) arranged perpendicularly to the top surface (110) of the substrate (100), each vertical n-type semiconductor pillar (124) having a bottom end (125) facing the top surface (110) of the substrate (100), and a top end (127) facing away from the top surface (110) of the substrate (100), the plurality of vertical n-type semiconductor pillars (124) being clustered into one or more sets of n-type semiconductor pillars (124), wherein each of the one or more sets of n-type semiconductor pillars (124) constitutes a n-type thermoelement (120n),
wherein the n-type (120n) and p-type (120p) thermoelements are located at distance (D1) from each other such that a space (130) is formed between the n-type (120n) and p-type (120p) thermoelements;
a bottom contact layer (140) defining a plurality of discrete bottom contact portions (140), wherein each bottom contact portion (140) connects the bottom ends (121) of the vertical p-type semiconductor pillars (122) of a specific p-type thermoelement forming a bottom contact of the specific p-type thermoelement or connects the bottom ends (125) of the vertical n-type semiconductor pillars (124) of a specific n-type thermoelement (120n) forming a bottom contact of the specific n-type thermoelement (120n); and
a top contact layer (150) defining a plurality of discrete top contact portions, wherein each top contact portion connects the top ends (123) of the vertical p-type semiconductor pillars (122) of a specific p-type thermoelement (120p) forming a top contact of the specific p-type thermoelement (120p) or connects the top ends (127) of the vertical n-type semiconductor pillars (124) of a specific n-type thermoelement (120n) forming a top contact of the specific n-type thermoelement (120n).

2. The semiconductor structure (200) according to claim 1,
wherein the p-type semiconductor pillars (122) are clustered into a plurality of sets of p-type semiconductor pillars (122),
wherein the n-type semiconductor pillars (124) are clustered into a plurality of sets of n-type semiconductor pillars (124),
wherein bottom contact portions (140) of the bottom contact layer is arranged to connect bottom contacts (125) of the n-type thermoelements (120n) and bottom contacts (121) of the p-type thermoelements (120p) and wherein top contact portions (150) of the top contact layer (150) are arranged to connect top contacts (127) of the n-type thermoelements (120n) and the top contacts of the p-type thermoelements (120p) such that the n-type (120n) and p-type thermoelements (120p) are connected in series.

3. The semiconductor structure (200) according to claim 1 or 2, wherein the space (130) between the n-type (120n) and p-type thermoelements (120p) comprises a passivating material.

4. The semiconductor structure (200) according to any one of claims 1-3, wherein the p-type semiconductor pillars (122) comprises InₓGa₁₋ₓN, wherein 0.2<x<0.35, and wherein the n-type semiconductor pillars (124) comprises In_{y}Ga_{1-y}N, wherein 0.2<y<0.35.

5. The semiconductor structure (200) according to any one of claims 1-4, wherein the bottom contact layer (140) comprises doped GaN.

6. The semiconductor structure (200) according to any one of claims 1-5, wherein the top contact layer (150) is metallic.

7. The semiconductor structure (200) according to any one of claims 1-6, wherein the p-type semiconductor pillars (122) comprises a superlattice of InₓGa₁₋ₓN, wherein 0.2<x<0.35, and InN, and wherein the n-type semiconductor pillars (124) comprises a superlattice of In_{y}Ga_{1-y}N, wherein 0.2<y<0.35, and InN.

8. The semiconductor structure (200) according to any one of claims 1-7, wherein the substrate (100) comprises Si.

9. The semiconductor structure (200) according to claim 7, further comprising a supporting layer (106) arranged in between the Si-substrate (102) and the thermoelement layer (120), wherein the supporting layer (106) comprises:
a first semiconductor layer (105) arranged on the Si-substrate (102), the first semiconductor layer (105) comprising a plurality of vertical nanowire structures (103) arranged perpendicularly to the top surface (104) of the Si-substrate (102), the first semiconductor layer (105) comprising AIN, and
a second semiconductor layer (107) arranged on the first semiconductor layer (105) laterally and vertically enclosing the nanowire structures (103), the second semiconductor layer (107) comprising Al_{z}Ga_{1-z}N, wherein 0≤z≤0.95.

10. A microfluidic system (300) comprising:
the semiconductor layer structure (200) according to any one of claims 1-9, wherein the thermoelement layer (120) is vertically divided in two or more regions (R1, R2, R3) wherein each region comprises at least one n-type thermoelement (120n) and at least one p-type thermoelement (120p) constituting a thermoelectric unit, wherein each thermoelectric unit is configured to supply a specific temperature upon a fixed current is running therethrough,
a microfluidic channel layer (310) arranged above the thermoelement layer (120), the microfluidic channel layer (310) comprising a microfluidic channel (320) having a meander extension across the two or more regions (R1, R2, R3) of the thermoelement layer (120) such that a fluid, while being transported in the channel (310), is exposable to a cyclic temperature variation.

11. The microfluidic system (300) according to claim 10, wherein the microfluidic channel layer (310) is made from a plastic material.

12. The microfluidic system (300) according to claim 10 or 11, wherein the microfluidic channel (320) comprises an inlet and an outlet.

13. The microfluidic system (300) according to any one of claims 10-12, further comprising a detector for detecting a biomarker, the detector comprising
an InGaN laser,
a microring resonator, and
a transducer.

14. The microfluidic system (300) according to claim 13, wherein the microring comprises a gold layer arranged on a top side or a bottom side of the microring.

15. The microfluidic system (300) according to any one of claims 10-14, the microfluidic system (300) being configured for polymerase chain reaction,
wherein the thermoelement layer (120) is vertically divided in at least three regions (R1, R2, R3),
wherein a first region (R1) comprises at least one n-type thermoelement (120n) and at least one p-type thermoelement (120p) constituting a first thermoelectric unit configured to supply a temperature of 95°C ±5%, for denaturation,
wherein a second region (R2) comprises at least one n-type thermoelement (120n) and at least one p-type thermoelement (120p) constituting a second thermoelectric unit configured to supply a temperature of 56°C ±5% for annealing of primers,
wherein a third region (R3) comprises at least one n-type thermoelement (120n) and at least one p-type thermoelement (120p) constituting a third thermoelectric unit configured to supply a temperature of 72°C ±5%, for extension by polymerase,
wherein the second region (R2) is abutting the first (R1) and third (R3) regions,
wherein the microfluidic channel (320) has a meander extension across the at least three regions (R1, R2, R3) of the thermoelement layer (120) such that a fluid, while being transported in the channel (320), is exposable to a cyclic temperature variation.
